Europäisches Patentamt

European Patent Office

Office européen des brevets

(11) Publication number: **0 134 606**
**B1**

# EUROPEAN PATENT SPECIFICATION

(45) Date of publication of patent specification: **15.03.89**

(51) Int. Cl.⁴: **H 01 L 21/68**

(21) Application number: **84201140.5**

(22) Date of filing: **02.08.84**

(54) Carrier film with conductive adhesive for dicing of semiconductor wafers.

(30) Priority: **03.08.83 US 519936**

(43) Date of publication of application:
**20.03.85 Bulletin 85/12**

(45) Publication of the grant of the patent:
**15.03.89 Bulletin 89/11**

(84) Designated Contracting States:
**BE CH DE FR GB IT LI NL SE**

(56) References cited:
**EP-A-0 134 623**
**DE-A-1 061 014**
**GB-A-1 151 926**
**US-A-4 285 433**
**US-A-4 339 486**

**PATENTS ABSTRACT OF JAPAN, vol. 6, no. 247
(E-146) 1125r, 7th December 1982; & JP-A-57
145 339**

**The file contains technical information
submitted after the application was filed and
not included in this specification**

(73) Proprietor: **National Starch and Chemical
Corporation
10 Finderne Avenue Box 6500
Bridgewater New Jersey 08807 (US)**

(72) Inventor: **Aurichio, Joseph Anthony
Route 10 Nottingham Way
Anderson, SC 29621 (US)**

(74) Representative: **Smulders, Theodorus A.H.J.
et al
Vereenigde Octrooibureaux Nieuwe Parklaan
107
NL-2587 BP 's-Gravenhage (NL)**

(56) References cited:
**PATENTS ABSTRACT OF JAPAN, vol. 6, no. 144
(E-122) 1022r, 3rd August 1982; JP-A-57 68053**
**PATENTS ABSTRACTS OF JAPAN, vol. 5, no.
179 (E-82) 851r, 17th November 1981; &
JP-A-56 107 563**

**PATENTS ABSTRACTS OF JAPAN, vol. 7, no.
88 (E-170) 1233r, 12th April 1983; & JP-A-58
15248**

Courier Press, Leamington Spa, England.

(56) References cited:

PATENTS ABSTRACTS OF JAPAN, vol. 6, no. 6
(E-89) 884r, 14th January 1982; & JP-A-56 126
937

PATENTS ABSTRACTS OF JAPAN, vol. 8, no.
155 (E-256) 1592r, 19th July 1984; & JP-A-59
57438

PATENTS ABSTRACTS OF JAPAN, vol. 8, no.
88 (E-240) 1525r, 21st April 1984; & JP-A-59
6551

PATENTS ABSTRACTS OF JAPAN, vol. 8, no.
81 (E-238) 1518r, 13th April 1984; & JP-A-59 930

## Description

Background of the invention

Field of the invention

The present invention relates to a product which is useful in the fabrication of semiconductor chips.

Description of related developments

Currently, silicon wafers with multiple printed circuitry are diced (or sawed) into individual circuits (chips) by first placing the wafer onto a dicing film (a polymeric support film having a tacky surface) which holds the wafer in place during the dicing operation. The wafer is then partially cut through its thickness by a dicing implement (e.g., a diamond-impregnated wheel). The wafer is then cracked into individual chips during a cracking procedure, and the chips are separated by stretching the support film. The chips are then picked up individually by a vacuum chuck to be placed into an appropriate chip carrier. A drop of conductive adhesive is placed onto the chip carrier where the chip is to be placed. The adhesive is then cured to secure the chip into place and provide a ground for the chip during the step in which wires are bonded to the chip.

It has also been suggested that both cost reduction and yield improvement can be achieved in the actual fabrication of the semiconductor products by elimination of the application of conductive adhesive to the chip carrier. This could be accomplished by applying conductive adhesive to the dicing film itself so that the adhesive and chip are attached to one another prior to the dicing step. During dicing the adhesive would hold the wafer on the support film. The dicing implement would cut through the entire thickness of the wafer, through the adhesive and only partially into the carrier film itself in order to still provide the needed support for the wafer. After dicing, the chips would be picked from the carrier film along with the conductive adhesive and would be placed onto the chip carrier. The adhesive would then be cured at the appropriate temperatures to develop the chip/carrier bond and the desired conductivity. EP—A—0 134 623, published on March 20, 1985, proposes a similar technique.

Although such a conductive adhesive/dicing film combination represents a theoretical improvement over the use of a dicing film having a mere surface tackiness, problems have been encountered in cleanly removing the wafer/adhesive combination from the support film after the wafer and adhesive have been brought into contact with one another.

Summary of the present invention

The present invention relates to an improved conductive adhesive/dicing film product which has a release layer between the conductive adhesive and the film which supports it. The use of the release layer facilitates easy removal of the adhesive with the attached chip, without destroying the integrity of the adhesive, and overcomes a serious problem noted with the conductive adhesive/dicing film product suggested by the prior art. In a preferred embodiment, the exposed surface of the adhesive is also covered with a suitable release liner to prevent contamination and/or injury to the adhesive.

Description of the drawings

The present is further illustrated by the Drawings, which form a portion of the present specification, wherein:

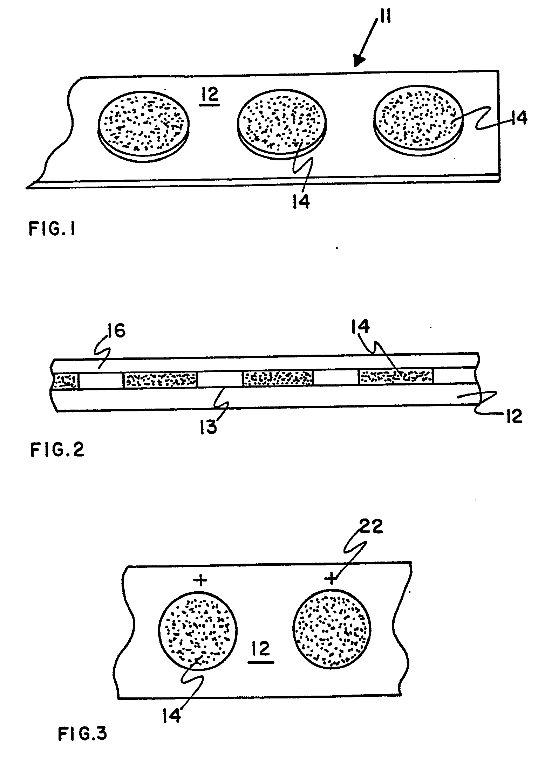

Figure 1 is a perspective view showing the dicing film and its adherent conductive adhesive patterns for contact with the printed wafer;

Figure 2 is an enlarged cross-sectional view of a section of the preferred embodiment of the dicing film of the present invention;

Figure 3 is an overhead view of a dicing film embodiment in accordance with the present invention;

Figure 4 shows an embodiment in which a wafer is about to be picked up for transfer to the dicing film;

Figure 5 illustrates alignment of the wafer and adhesive pattern preparatory to attachment of wafer and adhesive; and

Figure 6 shows the wafer/adhesive attachment procedure.

Detailed description of the present invention

The dicing film 11 of the present invention comprises a support film 12, an adherent release layer 13, and, attached to the release layer, a suitable pattern of conductive adhesive 14 to receive semiconductor wafers 15 for later dicing (not shown). The carrier film 12 needs to have sufficient support for the selected adhesive patterns while allowing such operations as oven drying. It needs to provide support, for example, for the cut chip after the dicing operation. The release layer 13 must allow for pick-up of the conductive adhesive/chip combination after the dicing operation without causing injury to the adhesive. The conductive adhesive 14 must have a sufficient level of conductivity, should have good smoothness to allow for full surface contact between it and the wafer and needs to be either dried or partially cured to a suitably tacky state and held in such a state for use at the wafer attachment stage. It needs to have a sufficient degree of cohesiveness to allow for its stripping from the support film without destruction of its physical integrity and also to allow stripping of an optional cover film therefrom. The conductive adhesive should have a suitable degree of thickness, e.g., from about 6 to about 38 μm (about 0.25 to about 1.5 mils) to

3

impart proper electrical requirements for grounding of the adhesive mounted chip to the ground plane. The present invention enables one to place the chip/adhesive combination in a chip carrier such that the adhesive supports the chip but does not cover any substantial area outside its support area. This allows for a more compact configuration for the necessary wires bonding the chip to the carrier, without increasing the possibility of short circuits arising due to close proximity of wire and conductive adhesive.

Representative support films which can be used in the dicing film product 11 of the present invention include paper as well as those made from such well known thermoplastic polymers as olefin polymers (e.g., polyethylene or polypropylene), vinyl halide polymers, and polyester. The thickness of the support film can range from about 25 to about 152 µm (about 1 to about 6 mils), with a thickness of 76—152 µm (3—6 mils) being preferred. Films having the preferred, greater thicknesses of 76—152 µm (3—6 mils) allow for a somewhat greater degree of safety in view of possible variation in the actual manufacturing tolerances in the dicing operation. An excessively thin film, if cut entirely through due to inherent variations in the manufacturing process, would not provide the needed support for the wafer.

Coated on one side of the support film is a suitable release layer 13 which, as will be mentioned below, allows for easy separation of the conductive adhesive/chip combination from the support film 12 after dicing. The release layer chosen for the product must be "tight" enough to allow for an acceptable degree of bonding of the conductive adhesive during the attachment and dicing operations. It must nevertheless be "light" enough to allow for release of the chip/adhesive combination after the dicing step without causing damage to the adhesive which must be reapplied to the chip carrier. Representative release layers can comprise silicone and fluorocarbon compositions such as those described in the prior art (e.g., in U.S. Patent Nos. 3,912,569 and 3,575,917 to A. M. Kapral). These release layers need only be thick enough to confer the desired release properties [e.g., from about 0.2 to about 0.9 kg (about 0.5 lb to about 2 lbs.) per ream]. If the surface of the support film has an inherent release layer function (polyfluorocarbon) the inherent release characteristics of its surface can be utilized in accordance with the present invention as the "release layer". A commercial source of suitable silicone release coated polymeric film (e.g., polypropylene with SILOX brand release coating) is Akrosil Corporation of Menasha, Wisconsin.

Attached to the exposed surface of the release layer is a suitable pattern of conductive adhesive 14 to form a point of attachment for the semiconductor wafers 15 that are to be diced. Generally, the conductive adhesive pattern can comprise a series of circular adhesive patterns of a suitable size [e.g., 25—152 mm (1—6 inches)] to approximate the diameter of the wafer to be mounted thereon. The thickness of the adhesive can range from about 5 to about 38 µm (about 0.2 mil to about 1.5 mils). Suitable conductive adhesive compositions which can be utilized include those adhesive materials which are loaded with fillers to effect conductivity requirements (e.g., 2% to about 75%, by weight of a suitable conductive material). Representative conductive materials include finely divided conductive metals (e.g., aluminum, copper, silver, gold, palladium), or carbon black. Representative adhesive materials which can form a matrix for the conductive materials include polyimide, acrylic, epoxy, silicones, and various modified polymeric materials to meet desired thermal and conductivity requirements.

In a preferred embodiment, the dicing film product 11 of the present invention also includes a suitable release liner 16 over the exposed surface of the adhesive to protect it from contamination and/or damage (e.g., inadvertent destruction of the preferred, substantially flat upper surface). For example, release coated paper can be employed as the release liner material. The release liner can have a differing release characteristic than the release layer.

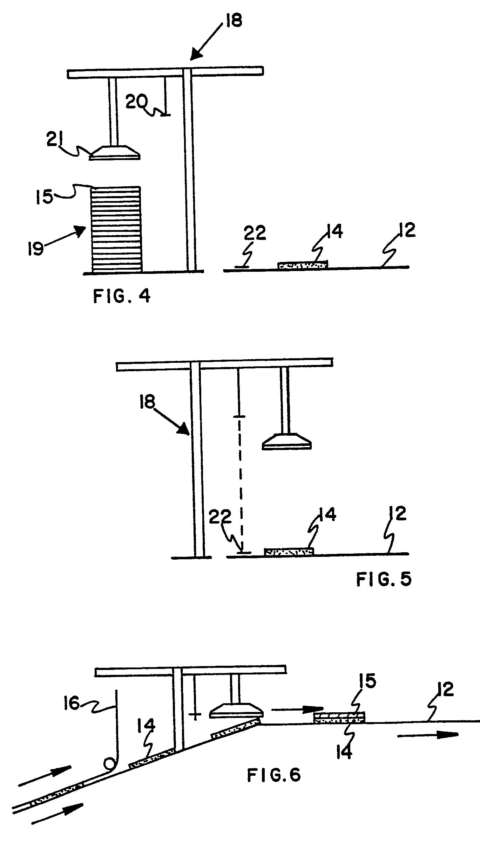

Figures 4—6 illustrate a manner in which the dicing film of the present invention can be used. Figure 4 shows a pivotal vacuum plate assembly about to pick up a semiconductor wafer from an array 19 of stacked wafers 15. Figure 5 illustrates the configuration of an electric eye 20 guided vacuum plate 21 in aligning wafer and adhesive in response to the registration mark 22 on the film 12. Figure 6 illustrates the wafer attachment step and also illustrates the prior stripping of the release liner 16 from the conductive adhesive 14/dicing film 12 combination.

The dicing film of the present invention can be formed using conventional lamination and printing operations. The release layer can, for example, be coated onto the support film by using conventional coating techniques followed by drying of the layer. The pattern of conductive adhesive is then applied to a dried release layer surface by appropriate printing procedures (e.g., rotary or flat bed screen printing) and then the adhesive is transferred to the support film 12 by lamination. If a release liner is desired over the exposed surface of the adhesive, it can also be applied by conventional lamination procedures.

The present invention is further illustrated by the Examples which follow.

Examples 1—6

The general procedure used to form all the samples involved screen printing of a suitable adhesive pattern [i.e., a succession of circles having a diameter of 76—102 mm (3—4 inches) and a thickness of about 25 µm (1 mil)] onto release coated paper. The release coated paper was 19 kg (42 pound) weight semi-bleached kraft paper. The adhesive was a silver modified polyimide (P-1011 brand from Epoxy Technology, Inc.). The resulting laminate was then oven dried for 30 minutes at 67°C (153°F).

The laminate made by the foregoing procedure was passed through a pressure nip with the selected support film such that the adhesive pattern faced the support film to laminate the adhesive pattern thereto. Sufficient pressure was used to effect such transfer. When the adhesive pattern had been transferred to the support film, the resulting laminate was heated for five minutes at 67°C (153°F) to dry the newly exposed side of the adhesive.

In these Examples a number of polypropylene support films were chosen for use. The film chosen for use in Example 1, as the control, was 127 μm (5.0 mil) polypropylene from Hercules and contained no release coating. In Examples 2—6 silicone release coated polypropylene from Akrosil Corporation was used having a thickness of 25—76 μm (1—3 mils) as described below:

| Example | Thickness in μm (mils) | Relative lightness/tightness* |
|---|---|---|
| 2 | 76 (3) | 4 |
| 3 | 51 (2) | 8 |
| 4 | 25 (1) | 8 |
| 5 | 76 (3) | 3 |
| 6 | 76 (3) | 2 |

* the relative lightness/tightness gives a rough estimate of how light or tight the release is. The lightest release is given a "1"; the tightest, a "10".

After the adhesive pattern has been transferred to the support films, the same type of paper originally used in the screenprinting of the adhesive was used as a cover sheet for the exposed surface of the adhesive pattern. This cover sheet was fed with the adhesive/support film laminate through two pressure nips so that the release coating and exposed surface of the adhesive pattern were brought together under sufficient pressure to bond the release paper and laminate. Alternatively, a thin polyester film or other suitable release coated polyolefin [e.g., about 25 μm (1 mil) in thickness] can be used as the cover sheet.

Examples 7—12

Each of the laminates made in Examples 1—6 was tested (after removal of the cover sheet) to determine if the adhesive separated readily from the support film. The following procedure was used. A silicon wafer was affixed to the adhesive by action of a squeegee to eliminate air entrapment. After attachment had been completed, an attempt was made by hand to remove the wafer and its attached adhesive cleanly from the support film.

The results obtained are as follows:

| Film made by Example | Results |
|---|---|
| 1 (Control) | Adhesive stuck to support film with only a small amount attached to the wafer. |
| 2 | Very good transfer to wafer with slight sticking of adhesive to support film. |
| 3 | Poor transfer to wafer due to tightness of release layer. |
| 4 | Poor transfer to wafer due to tightness of release layer. |
| 5 | Fair to good transfer to wafer. |
| 6 | Excellent transfer to wafer. |

The foregoing Examples should not be construed in a limiting sense since they only illustrate certain preferred embodiments of the present invention. The scope of protection sought is set forth in the claims which follow.

**Claims:**

1. A dicing film to support semiconductor wafers when they are diced into individual chips which comprises:

5

(a) a support film;

(b) a release layer on one side of the support film; and

(c) a pattern of conductive adhesive affixed to the release layer on said support film and consisting of a series of, adhesive patterns being of a size and shape to support at least one semiconductor wafer thereon, the release layer being adherent and allowing for pick-up of the conductive adhesive/chip combination after the dicing operation without causing damage to the conductive adhesive which must be reapplied to a chip carrier.

2. A film as claimed in claim 1 in which the support film is formed of a polyolefin polymer.

3. A film as claimed in claim 1 wherein the support film is polypropylene.

4. A film as claimed in claim 1 wherein the support film has a thickness of from about 25 to about 152 µm (about 1 mil to about 6 mils).

5. A film as claimed in claim 1 wherein the release layer comprises a silicone composition.

6. A film as claimed in claim 1 wherein the release layer comprises a fluorocarbon composition.

7. A film as claimed in claim 1 wherein the conductive adhesive has a thickness of from about 5 to about 38 µm (about 0.2 mil to about 1.5 mils).

8. A film as claimed in claim 1 wherein the conductive adhesive contains an effective amount for conductivity of a conductive metal in an adhesive matrix.

9. A film as claimed in claim 2 wherein the support film has a thickness of from about 25 to about 152 µm (about 1 mil to about 6 mils).

10. A film as claimed in claim 9 having a release layer which comprises a silicone composition.

11. A film as claimed in claim 10 having a conductive adhesive of a thickness of from about 5 to about 38 µm (about 0.2 mil to about 1.5 mils) and wherein the adhesive contains an effective amount for conductivity of a conductive metal in an adhesive matrix.

12. A film as claimed in claim 1 which also has a release liner over the pattern of conductive adhesive.

13. A film as claimed in claim 11 which also has a release liner over the pattern of conductive adhesive.

14. A process for forming individual chips from a semiconductor wafer which comprises:

(a) attaching the wafer to the adhesive pattern carried by the dicing film of claim 1; and

(b) dicing the wafer to form said chips.

15. A process as claimed in claim 14 wherein the wafer is placed on the adhesive by a vacuum plate assembly.

16. A process as claimed in claim 15 wherein the vacuum plate assembly is guided by means of a registration mark on the dicing film.

17. A process as claimed in claim 14 wherein the process also comprises removal of the chip from the film with placement in a chip carrier.

**Patentansprüche**

1. Trägerfilm für Halbleiterscheiben, wenn diese zu einzelnen Chips geschnitten werden, der umfaßt

(a) eine Trägerfolie,

(b) eine Trennschicht auf einer Seite des Trägerfolie und

(c) ein Muster eines leitenden Klebstoffes, befestigt an der Trennschicht der Trägerfolie und bestehend aus einer Reihe von Klebstoffmustern einer Größe und Form, um mindestens eine Halbleiterscheibe darauf zu tragen, wobei die Trennschicht klebend ist und das Abheben der Kombination aus lietendem Klebstoff/Chip nach dem Schneidevorgang zuläßt, ohne eine Beschädigung des leitenden Klebstoffes zu verursachen, der wieder auf einen Chipträger aufgebracht werden muß.

2. Film nach Anspruch 1, in welchem die Trägerfolie aus einem Polyolefinpolymer gebildet ist.

3. Film nach Anspruch 1, worin die Trägerfolie Polypropylen ist.

4. Film nach Anspruch 1, worin die Trägerfolie eine Dicke von etwa 25 bis 152 µm (etwa 1 mil bis 6 mil) hat.

5. Film nach Anspruch 1, worin die Trennschicht eine Siliconzusammensetzung umfaßt.

6. Film nach Anspruch 1, worin die Trennschicht eine Fluorkohlenstoffzusammensetzung umfaßt.

7. Film nach Anspruch 1, worin der leitende Klebstoff eine Dicke von etwa 5 bis 38 µm (etwa 0,2 mil bis 1,5 mil) hat.

8. Film nach Anspruch 1, worin der leitende Klebstoff eine für die Leitfähigkeit wirksame Menge eines leitenden Metalls in einer Klebstoffgrundmasse enthält.

9. Film nach Anspruch 2, worin die Trägerfolie eine Dicke von etwa 25 bis 152 µm (etwa 1 mil bis etwa 6 mil) hat.

10. Film nach Anspruch 9 mit einer Trennschicht, die eine Siliconzusammensetzung umfaßt.

11. Film nach Anspruch 10 mit einem leitenden Klebstoff einer Dicke von etwa 5 bis 38 µm (etwa 0,2 mil bis 1,5 mil) und worin der Klebstoff eine für die Leitfähigkeit wirksame Menge eines leitenden Metalls in einer Klebstoffgrundmasse enthält.

12. Film nach Anspruch 1, der weiterhin eine Abdeck- bzw. Trennbeschichtung über dem Muster des leitenden Klebstoffes aufweist.

13. Film nach Anspruch 11, der weiterhin eine Abdeck- bzw. Trennbeschichtung über dem Muster des leitenden Klebstoffes aufweist.

14. Verfahren zur Herstellung einzelner Chips aus einer Halbleiterscheibe, das umfaßt:

(a) das Befestigen der Scheibe auf dem von der Folie getragenen Klebstoffmuster gemäß Anspruch 1 und

(b) das Schneiden der Scheibe zur Bildung der Chips.

15. Verfahren nach Anspruch 14, worin die Scheibe durch Montage mittels Vakuumplatte auf dem Klebstoff plaziert wird.

16. Verfahren nach Anspruch 15, worin die Montage mittels Vakuumplatte durch Registriermarkierung auf dem Film gesteuert wird.

17. Verfahren nach Anspruch 14, worin dieses auch die Entfernung des Chips vom Film mit dem Einsetzen in einen Chipträger umfaßt.

**Revendications**

1. Un film sécable pour support de plaquettes semiconductrices lorsqu'elles sont découpées en puces individuelles, comprenant:

a) un film de support

b) une couche de décollage sur un côté du film de support; et

c) un dessin d'adhésif conducteur fixé à la couche de décollage sur ledit film de support, et comprenant une série de dessins adhésifs d'une taille et d'une forme capables de supporter au moins une plaquette semiconductrice, la couche de décollage étant adhérente et permettant le prélèvement de la combinaison adhésif conducteur/puce, après l'opération de coupe, sans causer de dommage à l'adhésif conducteur qui doit être réappliqué à un support de puce.

2. Un film comme revendiqué à la revendication 1, dans lequel le film de support est formé d'un polymère de polyoléfine.

3. Un film comme revendiqué à la revendication 1, dans lequel le film de support est en polypropylène.

4. Un film comme revendiqué à la revendication 1, dans lequel le film de support a une épaisseur d'environ 25 à environ 152 µm (environ 1 mil à environ 6 mils).

5. Un film comme revendiqué à la revendication 1, dans lequel la couche de décollage comprend une composition de silicone.

6. Un film comme revendiqué à la revendication 1, dans lequel la couche de décollage comprend une composition de fluorocarbone.

7. Un film comme revendiqué à la revendication 1, dans lequel l'adhésif conducteur a une épaisseur d'environ 5 à environ 38 µm (environ 0,2 mil à environ 1,5 mils).

8. Un film comme revendiqué à la revendication 1, dans lequel l'adhésif conducteur contient une quantité effective de métal conducteur dans une matrice adhésive pour assurer la conductivité.

9. Un film comme revendiqué à la revendication 2, dans lequel le film de support a une épaisseur d'environ 25 à environ 152 µm (environ 1 mil à environ 6 mils).

10. Un film comme revendiqué à la revendication 9, présentant une couche de décollage comprenant une composition de silicone.

11. Un film comme revendiqué à la revendication 10, présentant un adhésif conducteur d'une épaisseur d'environ 5 à environ 38 µm (environ 0,2 mil à environ 1,5 mils) et dans lequel l'adhésif contient une quantité effective de métal conducteur dans une matrice adhésive pour assurer la conductivité.

12. Un film comme revendiqué à la revendication 1, présentant également un revêtement de décollage sur le dessin d'adhésif conducteur.

13. Un film comme revendiqué à la revendication 11, présentant également un revêtement de décollage sur le dessin d'adhésif conducteur.

14. Un procédé pour former des puces individuelles à partir d'une plaquette semi-conductrice qui comprend:

a) la fixation de la plaquette au dessin adhésif porté par le film sécable de la revendication 1, et

b) le découpage de la plaquette pour former lesdites puces.

15. Un procédé comme revendiqué à la revendication 14, dans lequel la plaquette est placée sur l'adhésif par un montage à plaque à vide.

16. Un procédé comme revendiqué à la revendication 15, dans lequel le montage à plaque à vide est guidé au moyen d'un marquage d'enregistrement sur le film sécable.

17. Un procédé comme revendiqué à la revendication 14, dans lequel le procédé comprend aussi l'enlèvement de la puce du film et son placement dans un support de puce.

11

12

14

14

FIG.1

16

14

13

12

FIG.2

22

+

+

12

14

FIG.3

1

FIG. 4

FIG. 5

FIG.6

2